# EUROPEAN PATENT APPLICATION

(11) **EP 4 576 088 A1**
(43) Date of publication of application: **25.06.2025**
(21) Application number: 24211782.8
(22) Date of filing: 08.11.2024
(51) Int. Cl.: G11C 5/14, G11C 17/16, G11C 17/18

(54) **A POWER CONDITIONING CIRCUIT FOR IN-FIELD FUSE PROGRAMMING**

(30) Priority: 20.12.2023 US 202318391158
(71) Applicant: Intel Corporation, Santa Clara, CA 95054 (US)
(72) Inventor: CHEN, Zhanping, Hillsboro, 97124 (US); KULKARNI, Sarvesh, Hillsboro, 97124 (US); MA, Rui, Portland (US); JUN, Joonha, Hillsboro (US)
(74) Representative: Viering, Jentschura & Partner mbB Patent- und Rechtsanwälte

(57) **Abstract**

An apparatus of a fuse array includes a bit cell coupled to a high voltage (HV) programming supply rail. The bit cell includes at least one P-channel metal-oxide semiconductor (PMOS) transistor. The fuse array further includes a column selection N-channel metal-oxide semiconductor (NMOS) device coupled to the bit cell. The column selection NMOS device includes a first NMOS transistor and a second NMOS transistor. The second NMOS transistor is configured to enable programming of the bit cell based on a program enable signal. The fuse array further includes a power multiplexer (MUX) coupled to the first NMOS transistor and configured to control voltage supplied to a gate of the first NMOS transistor based on a program control signal and the program enable signal.

## Description

### BACKGROUND

Metal-fuse-based Programmable Read Only Memory (PROM) is an essential memory for all technology nodes supporting multiple product applications. Traditional fuse programming applications include cache repair and analog circuit trimming. More recent applications include in-field fuse programming (IFP) that enables product reconfigurability by original equipment manufacturers (OEMs) or end users. Such traditional applications can be performed on high-volume manufacturing (HVM) testers and hence have sufficient flexibility in the provision of high voltage (HV) power supply levels that the fuse PROM requires for programming. For the case of IFP, however, the provision of additional fuse-dedicated supply rails in the product package is not a competitive option. Such supply constraints can challenge the ability to program the fuse bits successfully.

### BRIEF DESCRIPTION OF THE DRAWINGS

In the drawings, like numerals may describe the same or similar components or features in different views. Like numerals having different letter suffixes may represent different instances of similar components. Some embodiments are illustrated by way of example, and not limitation, in the figures of the accompanying drawings in which:
FIG. 1 is a block diagram of a fuse array with a programming path, in accordance with some embodiments;
FIG. 2 is a block diagram of a fuse array with example NMOS power management options, in accordance with some embodiments;
FIG. 3 is a block diagram of a column selection NMOS device with NMOS power management using a power multiplexer (MUX), in accordance with some embodiments;
FIG. 4 is a block diagram of a fuse array with NMOS power management using a power MUX including a transmission gate and a pass gate, in accordance with some embodiments;
FIG. 5 is a block diagram illustrating voltage swing at the output of a power MUX, in accordance with some embodiments;
FIG. 6 illustrates high voltage stress on gate-drain voltage (Vgd) of a fuse array, which is prevented by the disclosed power MUX, in accordance with some embodiments;
FIG. 7 illustrates a fuse array with NMOS power management using a power MUX and improving Vgd high voltage stress, in accordance with some embodiments;
FIG. 8 is a flow diagram of an example method for power management of a column selection NMOS device during fuse programming, in accordance with some embodiments; and
FIG. 9 illustrates a block diagram of an example machine upon which any one or more of the operations/techniques (e.g., methodologies) discussed herein may perform.

### DETAILED DESCRIPTION

The following detailed description refers to the accompanying drawings. The same reference numbers may be used in different drawings to identify the same or similar elements. In the following description, for purposes of explanation and not limitation, specific details are set forth, such as particular structures, architectures, interfaces, techniques, etc., to provide a thorough understanding of the various aspects of various embodiments. However, it will be apparent to those skilled in the art having the benefit of the present disclosure that the various aspects of the various embodiments may be practiced in other examples that depart from these specific details. In certain instances, descriptions of well-known devices, circuits, and methods are omitted so as not to obscure the description of the various embodiments with unnecessary detail.

The following description and the drawings sufficiently illustrate specific embodiments to enable those skilled in the art to practice them. Other embodiments may incorporate structural, logical, electrical, process, and other changes. Portions and features of some embodiments may be included in or substituted for those of other embodiments. Embodiments outlined in the claims encompass all available equivalents of those claims.

As used herein, the term "chip" (or die) refers to a piece of a material, such as a semiconductor material, that includes a circuit, such as an integrated circuit or a part of an integrated circuit. The term "memory IP" indicates memory intellectual property. The terms "memory IP," "memory device," "memory chip," and "memory" are interchangeable.

The term "a processor" configured to carry out specific operations includes both a single processor configured to carry out all of the operations (e.g., operations or methods disclosed herein) as well as multiple processors individually configured to carry out some or all of the operations (which may overlap) such that the combination of processors carry out all of the operations.

The disclosed techniques can be used to maintain platform compatibility for IFP limits available rails to the commonly available HV input and output (I/O) rail (labeled as HV or Vccfhv with a typical value of 1.8V, but it can be at other voltage levels such as 1.6V, 1.7V, 1.9V, 2.0V, or even higher) and a low-voltage (LV) core rail (e.g., Vccf with a typical value of 0.75V, but it can be lower such as 0.5V, 0.55V, etc., and can be higher such as 0.825V, 0.9V, 1.0V, 1.1V, et.). As used herein, the terms HV and Vccfhv are used interchangeably in the present disclosure. Additionally, the terms LV and Vccf are also used interchangeably in the present disclosure. As these supply constraints challenge the ability to successfully program the fuse bits, the disclosed gate-overdrive switching circuit solution can be used to enable IFP. As detailed ahead, the solution does not incur the area, current, and design complexity requirements of alternatives such as using embedded charge pumps or device upsizing. Reliability challenges associated with the HV usage are solved in the disclosed power conditioning switch design by ensuring that the gate voltage is boosted (e.g., from 0.75V to 1.8V) only for the single column addressed for programming while unselected columns are parked at the LV core supply level (e.g., 0.75V).

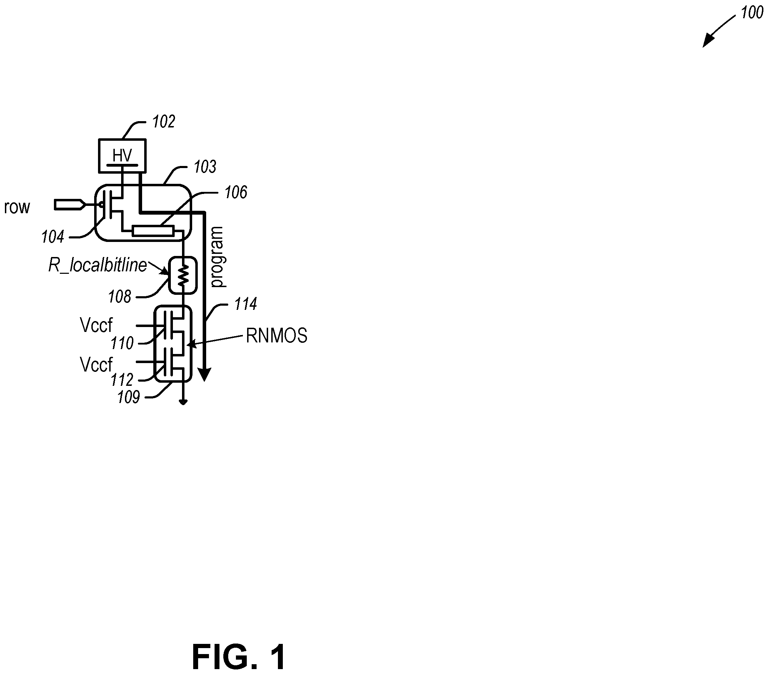

FIG. 1 is a block diagram of a fuse array 100 with a programming path, in accordance with some embodiments. FIG. 1 also shows the key components on the programming path of the fuse array 100. The fuse array 100 includes a bit cell 103 with PMOS access transistor 104 (also referred to as RPMOS) and metal fuse element 106 (also referred to as RFUSE), a shared column selection NMOS device 109 (also referred to as RNMOS), and a distributed parasitic bit line resistance 108 (also referred to as R_localbitline). The shared column selection NMOS device 109 includes NMOS transistors 110 and 112. In some aspects, the program sequence turns on the PMOS of the selected row and the NMOS of the selected column to address a particular bit in the array. A large enough current can flow through the element to successfully program it via program path 114. In some aspects, the 1.8V rail is applied at node 102 (marked HV) to provide the power to program a fuse. In some aspects, the disclosed techniques can be used to optimize the column selection NMOS device 109.

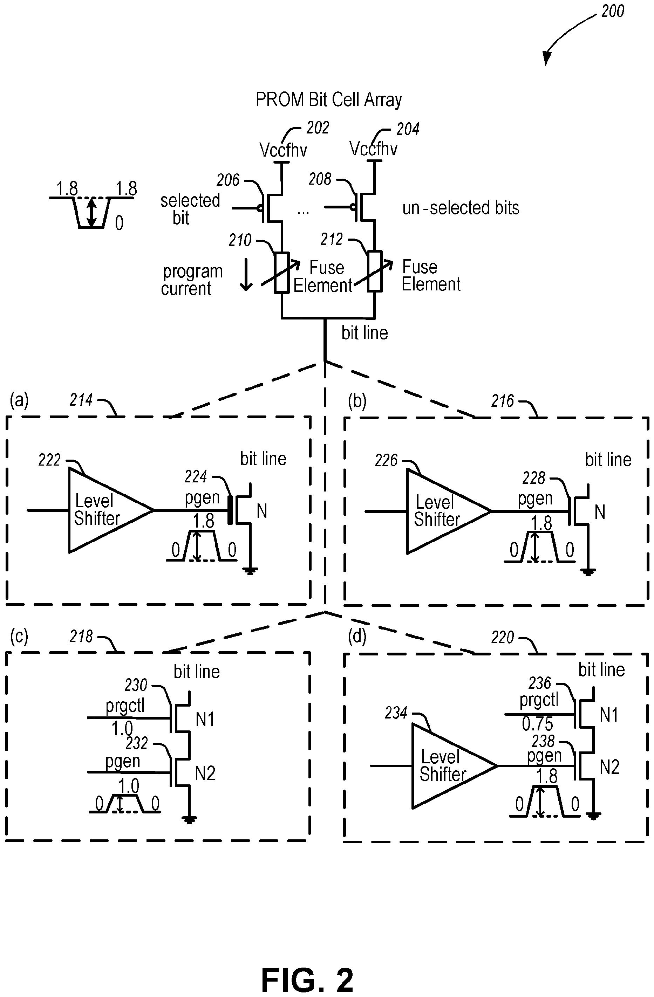

FIG. 2 is a block diagram of a fuse array 200 with example NMOS power management options, in accordance with some embodiments. Referring to FIG. 2, fuse array 200 includes bit cells with corresponding PMOS access transistors 206 - 208 coupled to HV programming supply rails 202 - 204 (also referred to as Vccfhv) and fuse elements 210 - 212. The bit line of the bit cells is coupled to a shared column selection NMOS device 214, 216, 218, or 220 configured according to corresponding schemes (a), (b), (c), and (d) illustrated in FIG. 2.

FIG. 2 illustrates three different NMOS schemes in fuse designs across technology, which are indicated as schemes (a), (c), and (d). More specifically, NMOS scheme (a) in FIG. 2 has a level shifter 222 to overdrive an unstacked thick gate (TG) NMOS 224. The TG device can reliably sustain the HV (such as 1.8V) program voltage, and the resulting overdrive enables sufficient current flow for programming. However, TG devices are not supported by all process technologies.

For logic process technologies, a similar scheme (b) that uses level shifter 226 and replaces the TG column NMOS with a thin-gate (TnG) NMOS 228 may be considered if the thin-gate NMOS can tolerate HV stress. While this scheme will enable sufficient program current, it can fail reliability due to the HV exposure for NMOS devices as a thin gate NMOS usually cannot withstand HV as it has a significantly lower voltage headroom (Vmax/VBD). Specifically, the electrical over-stress (EOS) occurs as a long-duration gate-drain voltage (Vgd) of 1.8V for unselected columns on the selected row. This scheme also suffers from high leakage during programming as well as read and standby operations.

This motivates the NMOS scheme that uses stacked TnG devices (e.g., NMOS transistors 230 and 232) shown in scheme (c). During programming, the gate of the top NMOS N1(e.g., NMOS transistor 230) is always parked at a low core supply voltage (also referred to as Vccf), independent of whether the column is selected or unselected. The VGD reliability failure in the scheme (b) is thus reduced by Vccf and mitigated by the approach in scheme (c). This design can deliver enough program current as well if Vccf has the flexibility to be raised (typically to about 1V) during programming. However, scheme (c) cannot deliver sufficient program current for usages such as IFP as RNMOS becomes a bottleneck when Vccf is fixed at a significantly lower core logic supply of about 0.75V (0.675V-0.825V with 10% tolerance). To recover the program current loss, the column NMOS would need to be sized up by a factor of 5.85, significantly degrading the area metric.

NMOS scheme (d) in FIG. 2 includes NMOS transistors 236 and 238, and adds a level shifter 234 to overdrive the bottom NMOS transistor N2 to further boost up the program current. However, this scheme will not work if LV continues to decrease (e.g., 0.75V-10%=0.675V) with technology. To compensate for the current drop due to a reduced gate voltage, the NMOS would still need to be increased by a factor of 4 to deliver the program current target, causing significant area overhead.

The disclosed techniques include an NMOS overdrive scheme to overdrive both NMOS transistors N1 and N2 to meet the program current target without area overhead, leakage increase, HV exposure-induced reliability failures, or TG device usage.

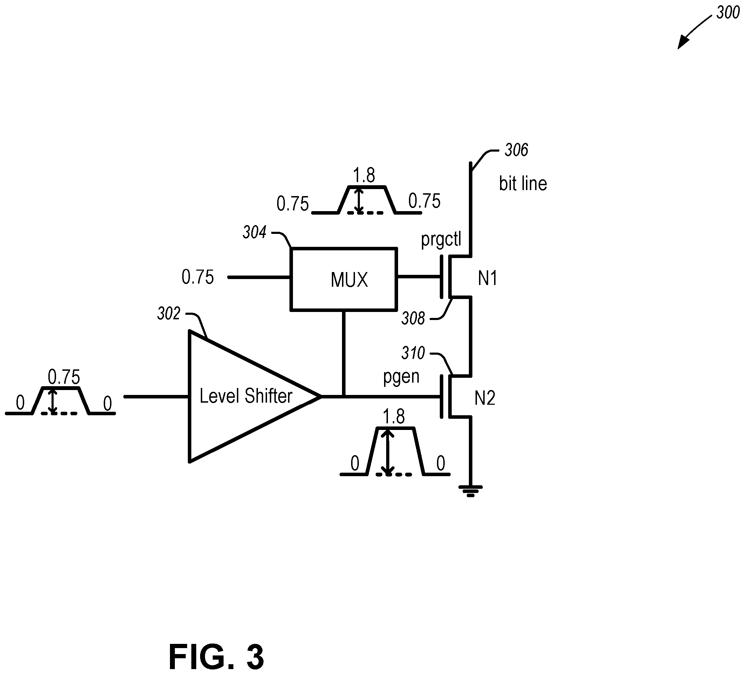

FIG. 3 is a block diagram of a column selection NMOS device with NMOS power management using a power multiplexer (MUX), in accordance with some embodiments. Referring to FIG. 3, the column selection NMOS device 300 includes NMOS transistors 308 and 310 coupled to a bit line 306, a level shifter 302, and a power MUX 304.

In some aspects, an HV power conditioning overdrive scheme can be used for in-field programming supporting common platform voltages, TnG process compatibility, and reliability. For example, power MUX 304, shown in Figure 3, is a novel power MUX that dynamically controls the top NMOS transistor N1 gate voltage conditional to the addressing during programming. Only when the column is addressed and enabled for programming are both top and bottom NMOS overdriven to boost up the program current. On the other hand, when the column is not selected for programming, the power MUX switches the top NMOS gate voltage back to LV (0.75V), thereby protecting both NMOS from reliability failure from HV exposure. The stacked NMOS design also minimizes leakage current.

Some of the advantages of using the disclosed techniques include the following:
(a) The new HV power conditioning overdrive scheme has significantly increased the program current at a fixed LV platform supply, such as 0.75V or lower.
(b) Maintain compatibility with TnG logic process technology. The disclosed HV power conditioning overdrive scheme minimizes the NMOS HV exposure time, eliminating the risk of gate-oxide breakdown.
(c) The disclosed HV power conditioning overdrive scheme maintains a current IP size, eliminating an area and leakage overhead from 4-5.85X upsizing of NMOS for matched program current.
(d) No special power delivery solutions like an embedded charge pump or LDO are required, reducing integration complexity and making the overall IP size more efficient. In some aspects, the proposed power MUX scheme can be used together with a charge pump to eliminate the requirement of an HV supply (such as 1.8V).

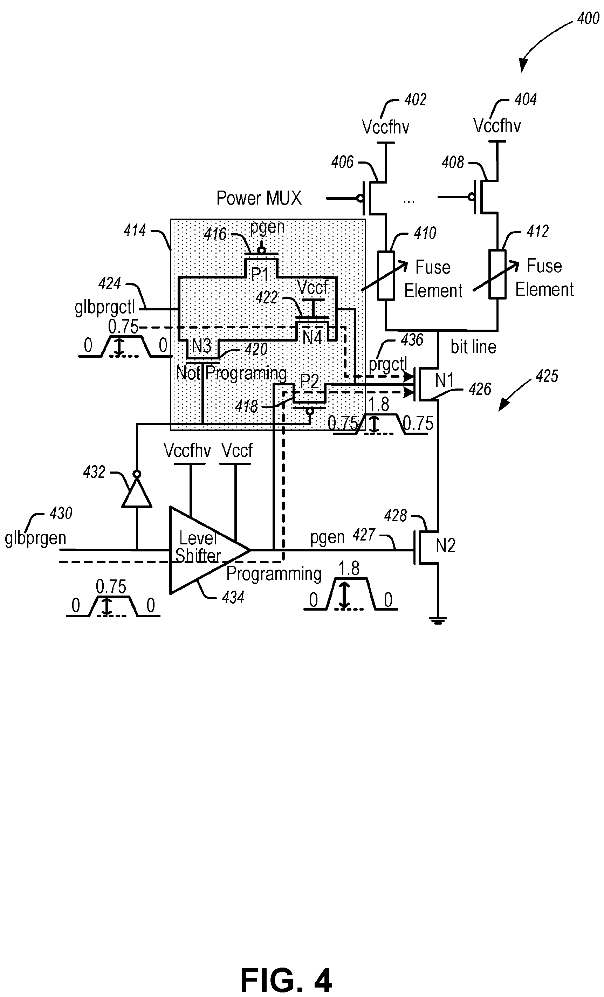

FIG. 4 is a block diagram of a fuse array 400 with NMOS power management using a power MUX including a transmission gate and a pass gate, in accordance with some embodiments. Referring to FIG. 4, the fuse array 400 includes bit cells with corresponding PMOS access transistors 406 - 408 coupled to HV programming supply rails 402 - 404 (also referred to as Vccfhv) and fuse elements 410 - 412. The bit line of the bit cells is coupled to a column selection NMOS device 425, including NMOS transistors 426 and 428. The fuse array 400 also includes a level shifter 434, an inverter 432, and a power MUX 414.

The power MUX 414 includes PMOS transistors 416 and 418 and NMOS transistors 420 and 422.

A program enable signal 430 (with a corresponding voltage level) is asserted at the input of the level shifter 434 and the inverter 432. A program control signal 424 (with a corresponding voltage level) is asserted at the input of the power MUX 414. The level shifter 434 also receives Vccfhv and Vccf voltages as inputs. In some aspects, Vccf is approximately about 0.75V, and Vccfhv is approximately about 1.8V.

The power conditioning overdrive scheme design of FIG. 4 solves the issue of providing sufficient program current while maintaining compatibility with platform power rails, TnG process technology, area, reliability, and leakage targets.

Vccfhv and Vccf are the HV programming supply and core supply, respectively. The power MUX 414 comprised of PMOS transistors 416 and 418 (also referred to as P1 and P2) and NMOS transistors 420 and 422 (also referred to as N3 and N4) biases program control voltage 436 (also referred to as prgctl) at the gate of the NMOS transistor 426 (also referred to as N1). These four transistors together ensure robust charge and discharge paths to prgctl to avoid coupling and slow performance when transitioning in and out of programming. In some aspects, the program control signal 424 (also referred to as glbprgctl) is preset to logic 1 (e.g., voltage at the core supply level of 0.75V) during programming.

When a bit cell is selected for programming, the program control signal 424 turns on to the core supply (Vccf) level of 0.75V. The level shifter 434 connected after the program enable signal 430 (also referred to as glbprgen) overdrives the program enable voltage 427 (also referred to as pgen) at the gate of the NMOS transistor 428 (also referred to as N2) to 1.8V. In power MUX 414, the P2 pass gate turns on to pass 1.8V to prgctl. As both of the stacked NMOS transistors (e.g., N1 and N2) are now overdriven to 1.8V, the program current target can be met and is insensitive to the low core supply voltage level.

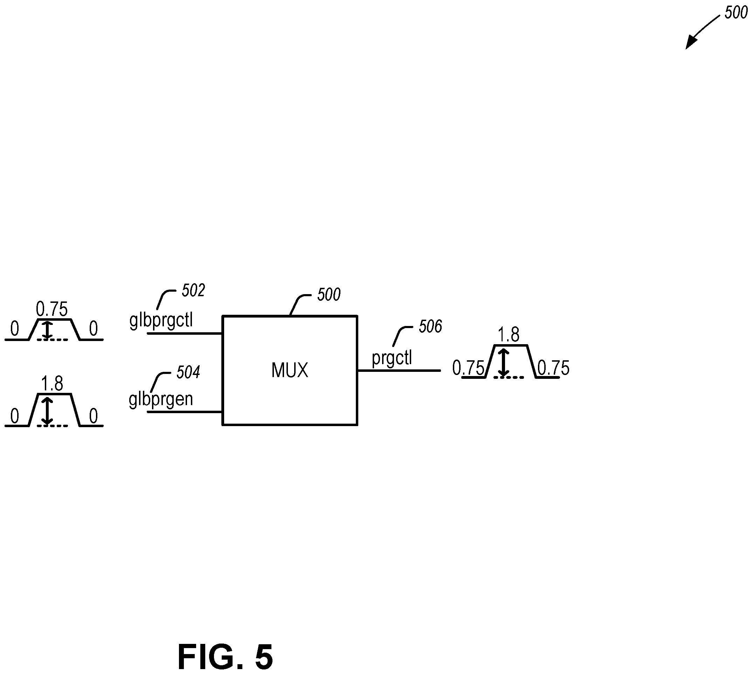

FIG. 5 is a block diagram illustrating voltage swing at the output of a power MUX in accordance with some embodiments. Referring to FIG. 5, power MUX 500 can be the same as power MUX 414. In some aspects, power MUX 500 receives as input program control signal 502 (which can be the same as program control signal 424) and program enable signal 504 (which can be the same as program enable signal 430) to generate program control voltage 506 (which can be the same as program control voltage 436).

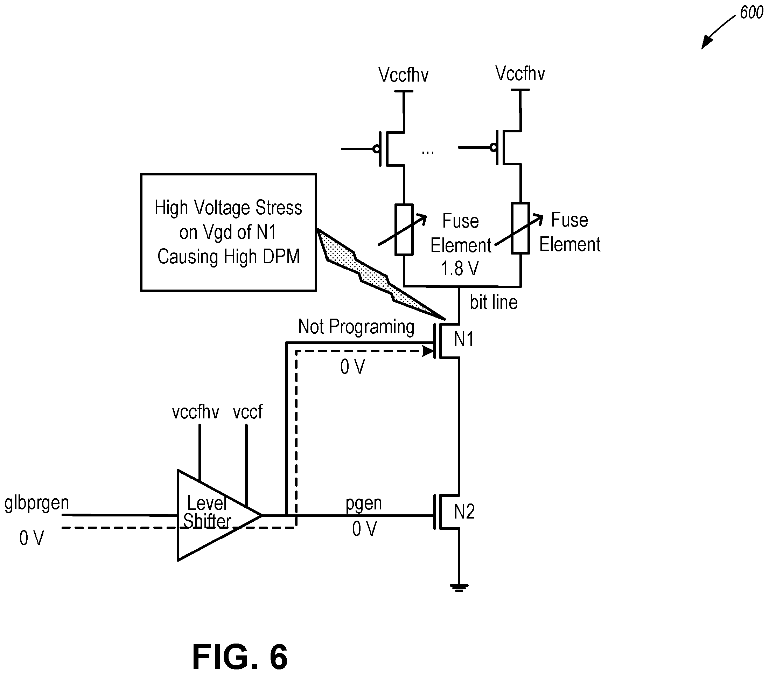

FIG. 6 illustrates diagram 600 of high voltage stress on gate-drain voltage (Vgd) of a fuse array, which is prevented by the disclosed power MUX, in accordance with some embodiments.

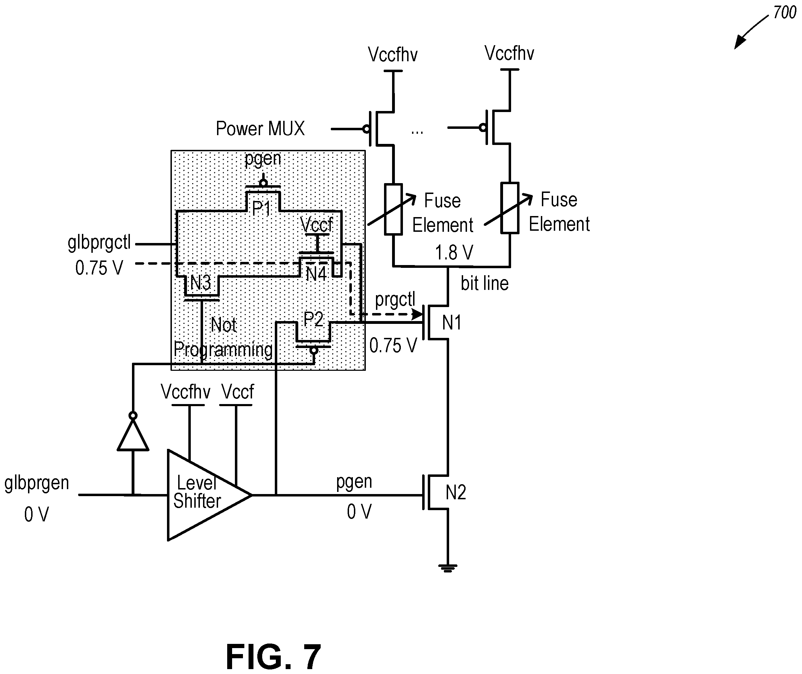

FIG. 7 illustrates diagram 700 of a fuse array with NMOS power management using a power MUX and improving Vgd high voltage stress, in accordance with some embodiments.

In addition to boosting the program current, the disclosed power MUX design also protects the reliability of both NMOS transistors in the array. The voltage swing at the output of the power MUX is shown in FIG. 5. When not used during the programming pulse for selected columns or for unselected columns, glbprgen is off at 0V, and the level shifter drives the gate of the bottom NMOS transistor N2 to 0V, disabling the programming path. If both N1 and N2 were to be overdriven without the power MUX, as shown in diagram 600 in FIG. 6, to achieve the same improved programming current, the top NMOS transistor N1 of unselected columns would see an HV gate-drain voltage Vgd exposure of 1.8V as unprogrammed bits on enabled rows will charge the bit line up to 1.8V. This worst-case stress duration cumulatively equals the time required for programming the entire array and results in a high failure probability in gate-oxide transistor configurations. On the other hand, for the proposed scheme shown in diagram 700 in FIG. 7, transistor P2 is OFF while transistors P1, N3, and N4 turn ON to pass 0.75V to prgctl. This ensures no HV exposure for both transistors N1 and N2 when the bit line is at 1.8V.

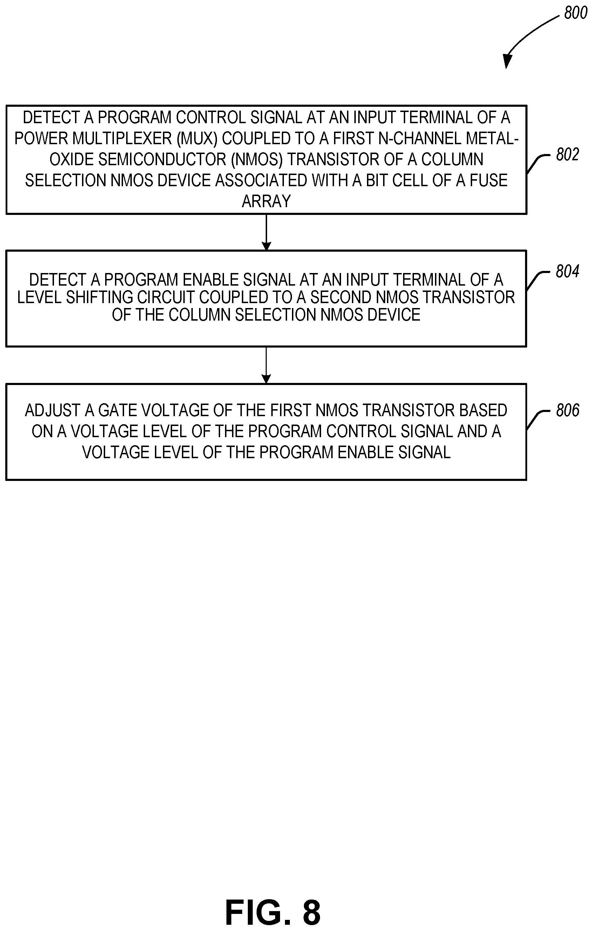

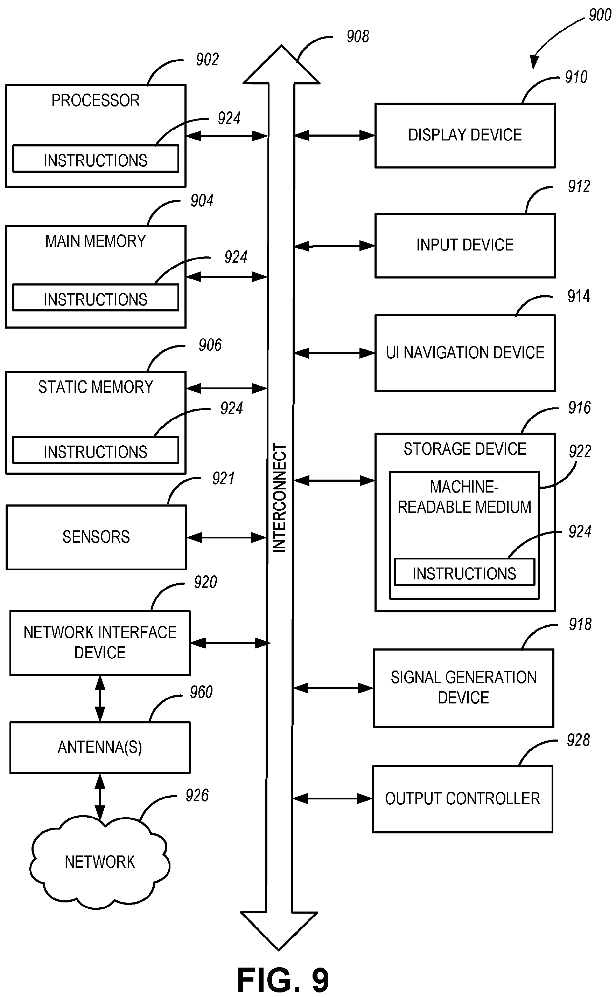

FIG. 8 is a flow diagram of an example method 800 for power management of a column selection NMOS device during fuse programming, in accordance with some embodiments. Referring to FIG. 8, method 800 includes operations 802, 804, and 806, which may be executed by an embedded controller or another processor of a computing device (e.g., hardware processor 902 of machine 900 illustrated in FIG. 9, which can include one or more of the circuits discussed in connection with FIGS. 1-7). In some embodiments, one or more of the circuits discussed in connection with FIGS. 1-7 can perform the functionalities listed in FIG. 8, as well as in the examples listed below.

At operation 802, a program control signal (e.g., program control signal 424) is detected at an input terminal of a power multiplexer (MUX) (e.g., power MUX 414) coupled to a first N-channel metal-oxide semiconductor (NMOS) transistor (e.g., NMOS transistor 426) of a column selection NMOS device (e.g., column selection NMOS device 425) associated with a bit cell of a fuse array (e.g., fuse array 400).

At operation 804, a program enable signal (e.g., the program enable signal 430) is detected at an input terminal of a level shifting circuit (e.g., level shifter 434) coupled to a second NMOS transistor (e.g., NMOS transistor 428) of the column selection NMOS device.

At operation 806, the gate voltage of the first NMOS transistor is adjusted based on the voltage level of the program control signal and the voltage level of the program enable signal. For example, the power MUX 414 generates program control voltage 436, at least based on the program enable signal 430, and the resulting program enable voltage 427 is generated by the level shifter 434.

FIG. 9 illustrates a block diagram of an example machine 900 upon which any one or more of the techniques (e.g., methodologies) discussed herein may perform. In alternative embodiments, the machine 900 may operate as a standalone device or may be connected (e.g., networked) to other machines. In a networked deployment, machine 900 may operate in the capacity of a server machine, a client machine, or both in server-client network environments. In an example, machine 900 may function as a peer machine in a peer-to-peer (P2P) (or other distributed) network environment. The machine 900 may be a personal computer (PC), a tablet PC, a set-top box (STB), a personal digital assistant (PDA), a portable communications device, a mobile telephone, a smartphone, a web appliance, a network router, switch or bridge, or any other computing device capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations. The terms "machine," "computing device," and "computer system" are used interchangeably.

Machine (e.g., computer system) 900 may include a hardware processor 902 (e.g., a central processing unit (CPU), a graphics processing unit (GPU), a hardware processor core, or any combination thereof), a main memory 904, and a static memory 906, some or all of which may communicate with each other via an interlink (e.g., bus) 908. In some aspects, the main memory 904, the static memory 906, or any other type of memory (including cache memory) used by machine 900 can be configured based on the disclosed techniques or can implement the disclosed memory devices.

Specific examples of main memory 904 include Random Access Memory (RAM) and semiconductor memory devices, which may include, in some embodiments, storage locations in semiconductors such as registers. Specific examples of static memory 906 include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; RAM; and CD-ROM and DVD-ROM disks.

Machine 900 may further include a display device 910, an input device 912 (e.g., a keyboard), and a user interface (UI) navigation device 914 (e.g., a mouse). In an example, the display device 910, the input device 912, and the UI navigation device 914 may be a touch screen display. The machine 900 may additionally include a storage device (e.g., drive unit or another mass storage device) 916, a signal generation device 918 (e.g., a speaker), a network interface device 920, and one or more sensors 921, such as a global positioning system (GPS) sensor, compass, accelerometer, or other sensors. The machine 900 may include an output controller 928, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.). In some embodiments, the hardware processor 902 and/or instructions 924 may comprise processing circuitry and/or transceiver circuitry.

The storage device 916 may include a machine-readable medium 922 on which one or more sets of data structures or instructions 924 (e.g., software) embodying or utilized by any one or more of the techniques or functions described herein can be stored. Instructions 924 may also reside, completely or at least partially, within the main memory 904, within static memory 906, or the hardware processor 902 during execution thereof by the machine 900. In an example, one or any combination of the hardware processor 902, the main memory 904, the static memory 906, or the storage device 916 may constitute machine-readable media.

Specific examples of machine-readable media may include non-volatile memory, such as semiconductor memory devices (e.g., EPROM or EEPROM) and flash memory devices; magnetic disks, such as internal hard disks and removable disks; magneto-optical disks; RAM; and CD-ROM and DVD-ROM disks.

While the machine-readable medium 922 is illustrated as a single medium, the term "machine-readable medium" may include a single medium or multiple media (e.g., a centralized or distributed database and/or associated caches and servers) configured to store instructions 924.

An apparatus of the machine 900 may be one or more of a hardware processor 902 (e.g., a central processing unit (CPU), a graphics processing unit (GPU), a hardware processor core, or any combination thereof), a main memory 904 and a static memory 906, one or more sensors 921, a network interface device 920, one or more antennas 960, a display device 910, an input device 912, a UI navigation device 914, a storage device 916, instructions 924, a signal generation device 918, and an output controller 928. The apparatus may be configured to perform one or more of the methods and/or operations disclosed herein. The apparatus may be intended as a component of machine 900 to perform one or more of the methods and/or operations disclosed herein and/or to perform a portion of one or more of the methods and/or operations disclosed herein. In some embodiments, the apparatus may include a pin or other means to receive power. In some embodiments, the apparatus may include power conditioning hardware.

The term "machine-readable medium" may include any medium that is capable of storing, encoding, or carrying instructions for execution by machine 900 and that causes machine 900 to perform any one or more of the techniques of the present disclosure or that is capable of storing, encoding, or carrying data structures used by or associated with such instructions. Non-limiting machine-readable medium examples may include solid-state memories and optical and magnetic media. Specific examples of machine-readable media may include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; Random Access Memory (RAM); and CD-ROM and DVD-ROM disks. In some examples, machine-readable media may include non-transitory machine-readable media. In some examples, machine-readable media may include machine-readable media that is not a transitory propagating signal.

The instructions 924 may further be transmitted or received over a communications network 926 using a transmission medium via the network interface device 920 utilizing any one of several transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), mobile telephone networks (e.g., cellular networks), Plain Old Telephone (POTS) networks, and wireless data networks (e.g., Institute of Electrical and Electronics Engineers (IEEE) 802.11 family of standards known as Wi-Fi^{®}, IEEE 802.16 family of standards known as WiMax^{®}), IEEE 802.15.4 family of standards, a Long Term Evolution (LTE) family of standards, a Universal Mobile Telecommunications System (UMTS) family of standards, peer-to-peer (P2P) networks, among others.

In an example, the network interface device 920 may include one or more physical jacks (e.g., Ethernet, coaxial, or phone jacks) or one or more antennas to connect to the communications network 926. In an example, the network interface device 920 may include one or more antennas 960 to wirelessly communicate using at least one single-input multiple-output (SIMO), multiple-input multiple-output (MIMO), or multiple-input single-output (MISO) techniques. In some examples, the network interface device 920 may wirelessly communicate using multiple-user MIMO techniques. The term "transmission medium" shall be taken to include any intangible medium that can store, encode, or carry instructions for execution by the machine 900 and includes digital or analog communications signals or other intangible media to facilitate communication of such software.

Examples, as described herein, may include, or may operate on, logic or several components, modules, or mechanisms. Modules are tangible entities (e.g., hardware) capable of performing specified operations and may be configured or arranged in a particular manner. In an example, circuits may be arranged (e.g., internally or concerning external entities such as other circuits) in a specified manner as a module. In an example, the whole or part of one or more computer systems (e.g., a standalone, client, or server computer system) or one or more hardware processors may be configured by firmware or software (e.g., instructions, an application portion, or an application) as a module that operates to perform specified operations. In an example, the software may reside on a machine-readable medium. In an example, the software, when executed by the underlying hardware of the module, causes the hardware to perform the specified operations.

Accordingly, the term "module" is understood to encompass a tangible entity, be that an entity that is physically constructed, specifically configured (e.g., hardwired), or temporarily (e.g., transitorily) configured (e.g., programmed) to operate in a specified manner or to perform part, all, or any operation described herein. Considering examples in which modules are temporarily configured, each of the modules need not be instantiated at any one moment in time. For example, where the modules comprise a general-purpose hardware processor configured using the software, the general-purpose hardware processor may be configured as respective different modules at separate times. The software may accordingly configure a hardware processor, for example, to constitute a particular module at one instance of time and to constitute a different module at a different instance of time.

Some embodiments may be implemented fully or partially in software and/or firmware. This software and/or firmware may take the form of instructions contained in or on a non-transitory computer-readable storage medium. Those instructions may then be read and executed by one or more processors to enable the performance of the operations described herein. The instructions may be in any suitable form, such as but not limited to source code, compiled code, interpreted code, executable code, static code, dynamic code, and the like. Such a computer-readable medium may include any tangible non-transitory medium for storing information in a form readable by one or more computers, such as but not limited to read-only memory (ROM), random access memory (RAM), magnetic disk storage media, optical storage media, flash memory, etc.

The above-detailed description includes references to the accompanying drawings, which form a part of the detailed description. The drawings show, by way of illustration, specific embodiments that may be practiced. These embodiments are also referred to herein as "examples." Such examples may include elements in addition to those shown or described. However, also contemplated are examples that include the elements shown or described. Moreover, also contemplated are examples using any combination or permutation of those elements shown or described (or one or more aspects thereof), either with respect to a particular example (or one or more aspects thereof) or with respect to other examples (or one or more aspects thereof) shown or described herein.

Publications, patents, and patent documents referred to in this document are incorporated by reference herein in their entirety, as though individually incorporated by reference. In the event of inconsistent usage between this document and those documents so incorporated by reference, the usage in the incorporated reference(s) is supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc., are used merely as labels and are not intended to suggest a numerical order for their objects.

The embodiments as described above may be implemented in various hardware configurations that may include a processor for executing instructions that perform the techniques described. Such instructions may be contained in a machine-readable medium such as a suitable storage medium or a memory or other processor-executable medium.

The embodiments as described herein may be implemented in several environments, such as part of a system on chip, a set of intercommunicating functional blocks, or similar, although the scope of the disclosure is not limited in this respect.

Described implementations of the subject matter can include one or more features, alone or in combination, as illustrated below by way of examples.

Example 1 is an apparatus comprising a first N-channel metal-oxide semiconductor (NMOS) transistor, a drain of the first NMOS transistor being coupled to a bit line; a second NMOS transistor, a drain of the second NMOS transistor being coupled to a source of the first NMOS transistor; a third NMOS transistor, a drain of the third NMOS transistor being coupled to a program control voltage rail; and a fourth NMOS transistor, a drain of the fourth NMOS transistor being coupled to a gate of the first NMOS transistor.

In Example 2, the subject matter of Example 1 includes a source of the third NMOS transistor coupled to a source of the fourth NMOS transistor.

In Example 3, the subject matter of Example 2 includes a gate of the fourth NMOS transistor coupled to a core supply voltage rail.

In Example 4, the subject matter of Example 3 includes a first P-channel metal-oxide semiconductor (PMOS) transistor, wherein a source of the first PMOS transistor is coupled to the program control voltage rail and the drain of the third NMOS transistor.

In Example 5, the subject matter of Example 4 includes a drain of the first PMOS transistor coupled to the drain of the fourth NMOS transistor.

In Example 6, the subject matter of Examples 4-5 includes a second PMOS transistor, wherein a source of the second PMOS transistor is coupled to the gate of the first NMOS transistor.

In Example 7, the subject matter of Example 6 includes an inverter, wherein an input terminal of the inverter is coupled to a program enable voltage rail, and an output terminal of the inverter is coupled to a gate of the second PMOS transistor.

In Example 8, the subject matter of Example 7 includes wherein the output terminal of the inverter is further coupled to a gate of the third NMOS transistor.

In Example 9, the subject matter of Examples 7-8 includes a level shifting circuit, wherein an input terminal of the level shifting circuit is coupled to the program enable voltage rail and an output terminal of the level shifting circuit is coupled to a gate of the second NMOS transistor.

In Example 10, the subject matter of Example 9 includes subject matter where the program enable voltage rail and the program control voltage rail supplies voltage of the core supply voltage rail.

In Example 11, the subject matter of Example 10 includes the voltage of the core supply voltage rail is between 0V and 0.75V.

In Example 12, the subject matter of Examples 1-11 includes at least one bit cell coupled to the bit line.

In Example 13, the subject matter of Example 12 includes wherein the at least one bit cell comprises a PMOS access transistor coupled to the bit line via a fuse element.

In Example 14, the subject matter of Example 13 includes a drain of the PMOS access transistor coupled to a high voltage (HV) programming supply rail and a source of the PMOS access transistor coupled to the fuse element.

In Example 15, the subject matter of Example 14 includes a gate of the PMOS access transistor coupled to a row selection voltage rail.

In Example 16, the subject matter of Examples 14-15 includes the HV programming supply rail supplies 1.8V.

In Example 17, the subject matter of Examples 1-16 includes one or more interconnects coupled to the first NMOS transistor, the second NMOS transistor, the third NMOS transistor, and the fourth NMOS transistor.

In Example 18, the subject matter of Examples 6-17 includes wherein the apparatus comprises a processor, and wherein the processor includes one or more of the first PMOS transistor, the second PMOS transistor, the third NMOS transistor, and the fourth NMOS transistor.

Example 19 is an apparatus of a fuse array comprising a bit cell coupled to a high voltage (HV) programming supply rail, the bit cell comprising at least one P-channel metal-oxide semiconductor (PMOS) transistor; a column selection N-channel metal-oxide semiconductor (NMOS) device coupled to the bit cell, the NMOS device comprising a first NMOS transistor and a second NMOS transistor, the second NMOS transistor configured to enable programming of the bit cell based on a program enable signal; and a power multiplexer (MUX) coupled to the first NMOS transistor and configured to control voltage supplied to a gate of the first NMOS transistor based on a program control signal and the program enable signal.

In Example 20, the subject matter of Example 19 includes subject matter where the power MUX is configured to detect that a voltage level of the program control signal is at a core supply voltage level and adjust the voltage supplied to the gate of the first NMOS transistor based on the core supply voltage level based on the programming of the bit cell being not enabled.

In Example 21, the subject matter of Example 20 includes subject matter where the power MUX comprises: a third NMOS transistor configured to receive the program control signal; a fourth NMOS transistor coupled to the third NMOS transistor; and a first PMOS transistor coupled to the third NMOS transistor and the fourth NMOS transistor.

In Example 22, the subject matter of Example 21 includes subject matter where a drain of the first PMOS transistor and a drain of the fourth NMOS transistor are configured to output the core supply voltage level to the gate of the first NMOS transistor based on the programming of the bit cell being not enabled.

In Example 23, the subject matter of Example 22 includes a level shifting circuit configured to receive the program enable signal and output program enable voltage to the second NMOS transistor, the program enable voltage based on the program enable signal.

In Example 24, the subject matter of Example 23 includes subject matter where the program enable voltage is at a voltage level of the HV programming supply rail.

In Example 25, the subject matter of Examples 23-24 includes subject matter where the power MUX comprises a second PMOS transistor coupled to the first PMOS transistor and the gate of the first NMOS transistor.

In Example 26, the subject matter of Example 25 includes subject matter where the second PMOS transistor is configured to receive the program enable voltage from the level shifting circuit.

In Example 27, the subject matter of Example 26 includes subject matter where the second PMOS transistor is configured to supply the program enable voltage to the gate of the first NMOS transistor in response to the programming of the bit cell being enabled based on the program enable signal.

In Example 28, the subject matter of Examples 19-27 includes one or more interconnects coupled to the bit cell, the column selection NMOS device, and the power MUX.

In Example 29, the subject matter of Examples 19-28 includes subject matter where the apparatus comprises a processor and wherein the processor includes one or more of the bit cell, the column selection NMOS device, and the power MUX.

In Example 30, the subject matter of Examples 19-29 includes one or more interconnects coupling two or more of the bit cell, the column selection NMOS device, and the power MUX.

Example 31 is a method comprising detecting a program control signal at an input terminal of a power multiplexer (MUX) coupled to a first N-channel metal-oxide semiconductor (NMOS) transistor of a column selection NMOS device associated with a bit cell; detecting a program enable signal at an input terminal of a level shifting circuit coupled to a second NMOS transistor of the column selection NMOS device; and adjusting a gate voltage of the first NMOS transistor based on a voltage level of the program control signal and a voltage level of the program enable signal.

In Example 32, the subject matter of Example 31 includes, detecting a voltage level of the program control signal is at a core supply voltage level; and adjusting the gate voltage of the first NMOS transistor based on the core supply voltage level in response to the program enable signal being de-asserted to indicate programming of the bit cell is not enabled.

In Example 33, the subject matter of Example 32 includes generating a program enable voltage based on the program enable signal and outputting the program enable voltage to the second NMOS transistor.

In Example 34, the subject matter of Example 33 includes subject matter where the program enable voltage is at a voltage level of a high voltage (HV) programming supply rail.

In Example 35, the subject matter of Examples 33-34 includes, supplying the program enable voltage to the gate of the first NMOS transistor in response to the programming of the bit cell being enabled based on the program enable signal.

Example 36 is an apparatus comprising means to perform a method as Exampleed in any preceding claim.

Example 37 is machine-readable storage including machine-readable instructions, which, when executed, cause a computing device to implement a method as Exampleed in any preceding claim.

Example 38 is machine-readable storage including machine-readable instructions, which, when executed, cause a power supply circuit to implement a method as provided in any preceding example.

Example 39 is a computer program comprising instructions which, when the program is executed by a computer, cause the computer to carry out the method as provided in any preceding example.

Example 40 is at least one machine-readable medium including instructions that, when executed by processing circuitry, cause the processing circuitry to perform operations to implement any of Examples 1-39.

Example 41 is an apparatus comprising means to implement any of Examples 1-39.

Example 42 is a system to implement any of Examples 1-39.

Example 43 is a method to implement any of Examples 1-39.

The above description is intended to be illustrative and not restrictive. For example, the above-described examples (or one or more aspects thereof) may be used in combination with others. Other embodiments may be used, such as by one of ordinary skill in the art upon reviewing the above description. The abstract is to allow the reader to ascertain the nature of the technical disclosure quickly. It is submitted with the understanding that it will not be used to interpret or limit the scope or meaning of the claims. Also, in the above Detailed Description, various features may be grouped to streamline the disclosure. However, the claims may not set forth every feature disclosed herein as embodiments may feature a subset of said features. Further, embodiments may include fewer features than those disclosed in a particular example. Thus, the following claims are hereby incorporated into the Detailed Description, with a claim standing on its own as a separate embodiment. The scope of the embodiments disclosed herein is to be determined regarding the appended claims, along with the full scope of equivalents to which such claims are entitled.

## Claims

1. An apparatus comprising:
a first N-channel metal-oxide semiconductor (NMOS) transistor, a drain of the first NMOS transistor being coupled to a bit line;
a second NMOS transistor, a drain of the second NMOS transistor being coupled to a source of the first NMOS transistor;
a third NMOS transistor, a drain of the third NMOS transistor being coupled to a program control voltage rail; and
a fourth NMOS transistor, a drain of the fourth NMOS transistor being coupled to a gate of the first NMOS transistor.

2. The apparatus of claim 1, wherein a source of the third NMOS transistor is coupled to a source of the fourth NMOS transistor.

3. The apparatus of claim 2, wherein a gate of the fourth NMOS transistor is coupled to a core supply voltage rail.

4. The apparatus of claim 3, further comprising:
a first P-channel metal-oxide semiconductor (PMOS) transistor, wherein a source of the first PMOS transistor is coupled to the program control voltage rail and the drain of the third NMOS transistor.

5. The apparatus of claim 4, wherein a drain of the first PMOS transistor is coupled to the drain of the fourth NMOS transistor.

6. The apparatus of any of claims 4-5, further comprising:
a second PMOS transistor, wherein a source of the second PMOS transistor is coupled to the gate of the first NMOS transistor.

7. A method comprising:
detecting a program control signal at an input terminal of a power multiplexer (MUX) coupled to a first N-channel metal-oxide semiconductor (NMOS) transistor of a column selection NMOS device associated with a bit cell;
detecting a program enable signal at an input terminal of a level shifting circuit coupled to a second NMOS transistor of the column selection NMOS device; and
adjusting a gate voltage of the first NMOS transistor based on a voltage level of the program control signal and a voltage level of the program enable signal.

8. The method of claim 7, further comprising:
detecting a voltage level of the program control signal is at a core supply voltage level; and
adjusting the gate voltage of the first NMOS transistor based on the core supply voltage level in response to the program enable signal being deasserted to indicate programming of the bit cell is not enabled.

9. The method of claim 8, further comprising:
generating a program enable voltage based on the program enable signal; and
outputting the program enable voltage to the second NMOS transistor.

10. Machine-readable storage including machine-readable instructions, when executed, cause the computer/transmitter/receiver to implement a method as claimed in any one of claim 7 to 9.

11. A computer program comprising instructions which, when the program is executed by a computer, cause the computer to carry out the method as claimed in any one of claims 7 to 9.
